# EUROPEAN PATENT APPLICATION

(11) **EP 4 765 305 A1**
(43) Date of publication of application: **24.06.2026**
(21) Application number: 24897975.9
(22) Date of filing: 15.11.2024
(51) Int. Cl.: H01M 10/42, G01R 31/3842, G01R 31/396

(54) **SENSOR ASSEMBLY AND BATTERY CELL TEST DEVICE COMPRISING SAME**

(30) Priority: 29.11.2023 KR 20230169144
(71) Applicant: LG Energy Solution, Ltd., Seoul 07335 (KR)
(72) Inventor: YOON, Sang Hyun, Daejeon 34122 (KR); SONG, Hyeon Jin, Daejeon 34122 (KR)
(74) Representative: Goddar, Heinz J.
(86) International application number: PCT/KR2024/018114
(87) International publication number: WO 2025/116379

(57) **Abstract**

The present disclosure relates to a battery cell testing device, and the battery cell testing device according to an aspect of the present disclosure is a battery cell testing device for determining characteristics of a battery cell, and includes a support frame configured to support the battery cell; and a sensor assembly disposed at a side of the support frame and configured to sense the characteristics of the battery cell, wherein the sensor assembly includes a sensor; and a holder coupled to the support frame to support the sensor.

## Description

### TECHNICAL FIELD

### CROSS-REFERENCE TO RELATED APPLICATIONS

The present application claims priority to Korean Patent Application No. 10-2023-0169144 filed on November 29, 2023 in the Republic of Korea, the disclosure of which is incorporated herein by reference.

### TECHNICAL FIELD

The present disclosure relates to a sensor assembly and a battery cell testing device including the same, and more particularly, to a sensor assembly for testing battery cell characteristics and a battery cell testing device including the same.

### BACKGROUND ART

Secondary batteries have been used in small-scale applications including mobile devices or laptop computers, but recently the direction of research is expanding to medium- and large-scale applications, and secondary batteries are being widely used in the industrial applications requiring high voltage and large capacity including Energy Storage Systems (ESSs) or Electric Vehicles (EVs). Secondary batteries may be manufactured and used in the form of battery cells.

Meanwhile, for research and development or testing of battery cells, it may be necessary to determine performance or characteristics. A predetermined testing device may be used. The conventional testing device determines the resistance, voltage, current or energy capacity of a battery cell by fixing the battery cell to a frame and charging and discharging the battery cell.

By the way, to evaluate the performance or characteristics of the battery cell, in some cases, physical quantities determined using sensors are used. For example, when an electric current flows in the battery cell, physical quantities of the battery cell such as temperature or pressure may be measured and analyzed for stability of products.

In this instance, the sensors preferably measure the characteristics of parts of the battery cell. It is because the temperature or pressure of the battery cell may be different for each part of the battery cell. Alternatively, with the diversity of the products, the battery cell may vary in shape.

Accordingly, there has been an urgent need for development of a sensor assembly in which the relative position between the sensor and the battery cell may be freely changed or controlled and a battery cell testing device including the same.

### SUMMARY

### TECHNICAL PROBLEM

The present disclosure is designed to solve the above-described problems, and therefore the present disclosure is directed to providing a sensor assembly in which the relative position between a sensor and a battery cell may be changed or controlled and a battery cell testing device including the same.

The problems of the present disclosure are not limited to the aforementioned problems, and these and other problems will be clearly understood by persons having ordinary skill in the technical field pertaining to the present disclosure from the following description.

### TECHNICAL SOLUTION

According to an aspect of the present disclosure, there is provided a battery cell testing device for determining characteristics of a battery cell, the battery cell testing device including a support frame configured to support the battery cell; and a sensor assembly disposed at a side of the support frame and configured to sense the characteristics of the battery cell, wherein the sensor assembly includes a sensor; and a holder coupled to the support frame to support the sensor.

In this instance, the holder may be detachably coupled to the support frame.

In this instance, the support frame may have a plate shape, and the holder may be coupled to a peripheral part of the support frame.

In this instance, the holder may include a holder body portion coupled to the support frame with at least part of the sensor disposed therebetween.

In this instance, the sensor may include a sensing portion supported by the holder body portion; and a connector portion extended outward from the support frame to electrically connect the sensing portion to an outside, and the holder may further include a connector support portion extended from the holder body portion to the outside of the support frame to support the connector portion.

In this instance, the connector support portion may be extended parallel to the connector portion.

In this instance, the connector support portion may have a connector support groove which is concavely recessed such that at least part of the connector portion is inserted into the connector support groove.

In this instance, the holder may further include a connector fixing portion formed on an outer surface of the connector support portion in a ring shape to catch the connector portion.

In this instance, the sensor may further include a substrate portion disposed between the sensing portion and the connector portion to connect them and placed on a side of the connector support portion, and the holder may further include a substrate fixing portion protruded outward from the connector support portion along a periphery of the substrate portion.

In this instance, the holder body portion may include a main body portion having a flat plate shape such that at least part of the sensor is disposed between the main body portion and a surface of the support frame.

In this instance, the holder body portion may include a sub body portion extended in a thickness direction of the support frame into contact with the side of the support frame; and a body connection portion configured to surround an edge at the periphery of the support frame to connect the main body portion to the sub body portion.

In this instance, the holder body portion may be coupled to the edge at the periphery of the support frame with a shape fit.

In this instance, the body connection portion may have a sensor support hole through which at least part of the sensor passes.

In this instance, the body connection portion may have a sensor support groove which is recessed such that the at least part of the sensor is placed on the sensor support groove, and the sensor support hole may be formed in an inner wall of the sensor support groove.

In this instance, the support frame may have a frame-side coupling hole at the peripheral part, the main body portion may have a holder-side coupling hole connected to the frame-side coupling hole, and the holder and the support frame may be coupled by a coupler passing through the frame-side coupling hole and the holder-side coupling hole.

In this instance, the frame-side coupling hole may include a plurality of frame-side coupling holes arranged at an interval along the periphery of the support frame, and the holder-side coupling hole may be connected to any one of the plurality of frame-side coupling holes.

In this instance, the support frame may include a first support frame and a second support frame arranged parallel to each other with the battery cell disposed therebetween, and the sensor assembly may include a first sensor assembly and a second sensor assembly coupled to the first support frame and the second support frame, respectively.

In this instance, the sensor assembly may include a first sensor assembly and a second sensor assembly disposed at two opposite sides of the support frame.

In this instance, the sensor assembly may include a first sensor assembly and a second sensor assembly arranged apart from each other side by side along a periphery of the support frame.

According to another aspect of the present disclosure, there is provided a sensor assembly for a battery cell for measuring characteristics of the battery cell, the sensor assembly including a sensor configured to sense the characteristics of the battery cell; and a holder configured to be coupled to a support frame for supporting the battery cell to support the sensor.

### ADVANTAGEOUS EFFECTS

According to an aspect of the present disclosure, as the holder for supporting the sensor may be separately provided and coupled to the support frame that supports the battery cell, the relative position between the battery cell and the sensor may be changed or controlled.

According to an aspect of the present disclosure, as the main body portion of the holder may be configured to be coupled to one surface of the support frame with the sensor disposed therebetween, the sensor may be protected from external pollution or shocks by the holder.

According to an aspect of the present disclosure, as the holder body portion of the holder may include the main body portion placed on one surface of the support frame and the sub body portion extended in the thickness direction of the support frame, the holder body portion may be coupled to the periphery of the support frame with a shape fit, so the position of the sensor may be stably fixed and supported.

According to an aspect of the present disclosure, as the connector support portion may be extended from the holder body portion to the outside of the support frame to support the connector portion, the connector portion of the sensor may be stably supported by the holder and protected from external shocks or pollution.

The effects of the present disclosure are not limited to the aforementioned effects, and these and other effects will be clearly understood by persons having ordinary skill in the technical field pertaining to the present disclosure from the specification and the accompanying drawings.

### BRIEF DESCRIPTION OF THE DRAWINGS

FIG. 1 is a perspective view of a battery cell testing device according to a first embodiment of the present disclosure when viewed from top.
FIG. 2 is a schematic diagram showing that a sensor assembly and a processor of a battery cell testing device according to a first embodiment of the present disclosure are electrically connected to a battery cell.
FIG. 3 is an exploded perspective view of a battery cell testing device according to a first embodiment of the present disclosure.
FIG. 4 is a perspective view of a sensor assembly of a battery cell testing device according to a first embodiment of the present disclosure when viewed from top.
FIG. 5 is a perspective view of a sensor assembly of a battery cell testing device according to a first embodiment of the present disclosure when viewed from bottom.
FIG. 6 is a cross-sectional perspective view of a battery cell testing device according to a first embodiment of the present disclosure, showing a coupling structure between a support frame and a sensor assembly.
FIG. 7 is a cross-sectional view of FIG. 6.
FIG. 8 is a cross-sectional perspective view of a battery cell testing device according to a first embodiment of the present disclosure, showing a sensing portion and a substrate portion of a sensor assembly.
FIG. 9 is a cross-sectional view of FIG. 8.
FIG. 10 is a plan view of a battery cell testing device according to a second embodiment of the present disclosure.
FIG. 11 is a plan view of a battery cell testing device according to a third embodiment of the present disclosure.
FIG. 12 is a perspective view of a battery cell testing device according to a fourth embodiment of the present disclosure when viewed from top.
FIG. 13 is an exploded perspective view of a battery cell testing device according to a fourth embodiment of the present disclosure.

### DETAILED DESCRIPTION

The exemplary embodiments of the present disclosure will be described in sufficient detail to enable those skilled in the art to easily carry out the present disclosure. However, the present disclosure may be embodied in many different forms and is not restricted or limited to the following embodiments.

To clearly describe the present disclosure, an irrelevant description or a detailed description of related known technology that may unnecessarily obscure the gist of the present disclosure is omitted, and in affixing the reference numerals to the elements in each drawing, the identical or similar reference numerals are affixed to the identical or similar elements throughout the specification.

Additionally, the terms or words used in the specification and the appended claims should not be construed as limited to general and dictionary meanings, but rather interpreted based on the meanings and concepts corresponding to the technical aspect of the present disclosure on the basis of the principle that the inventor is allowed to define the terms appropriately for the best explanation.

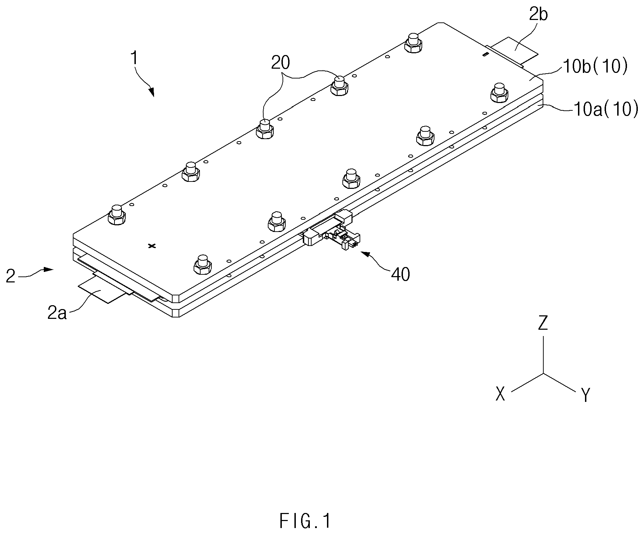

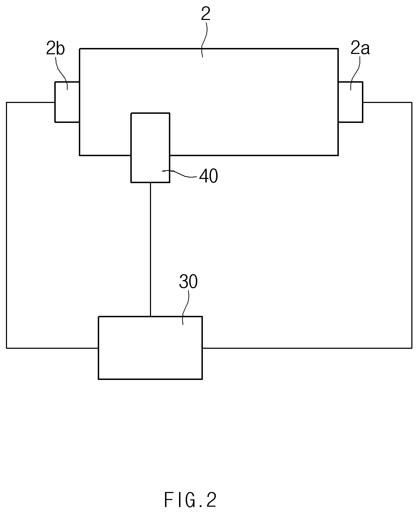

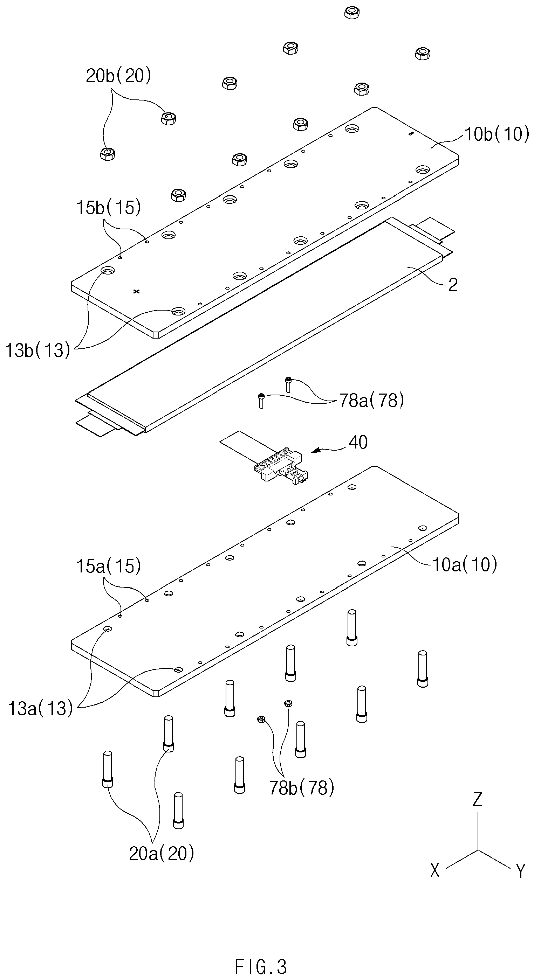

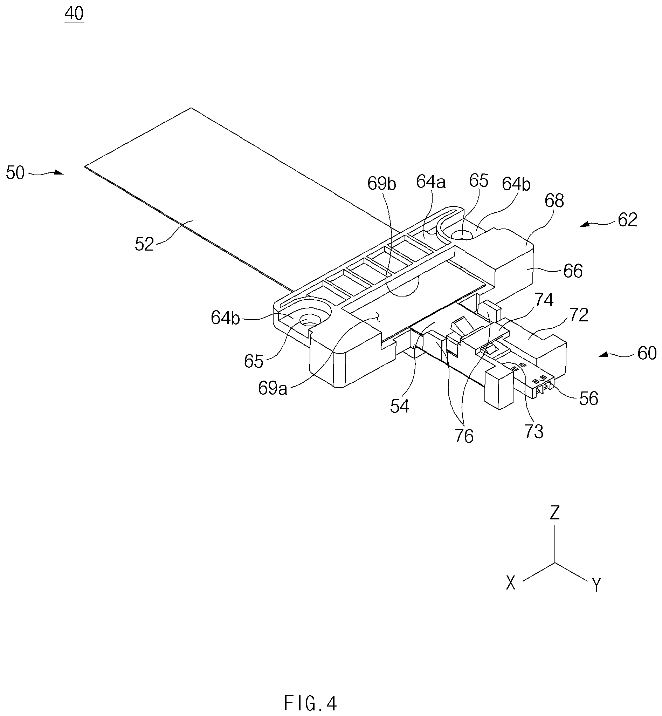

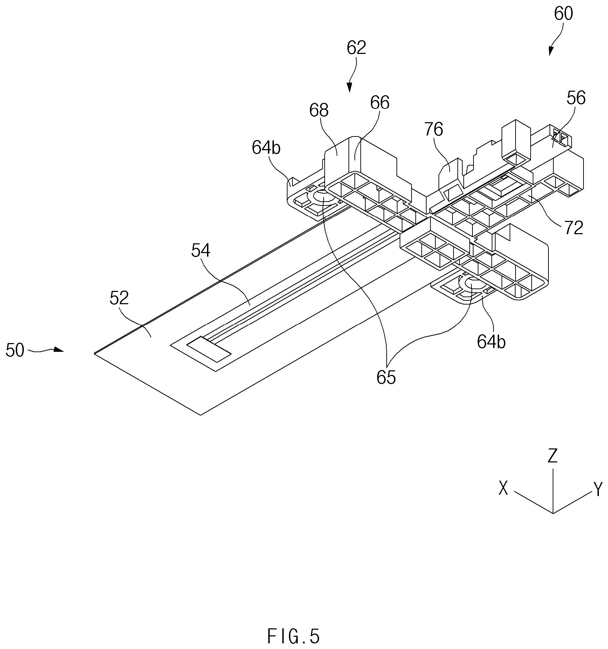

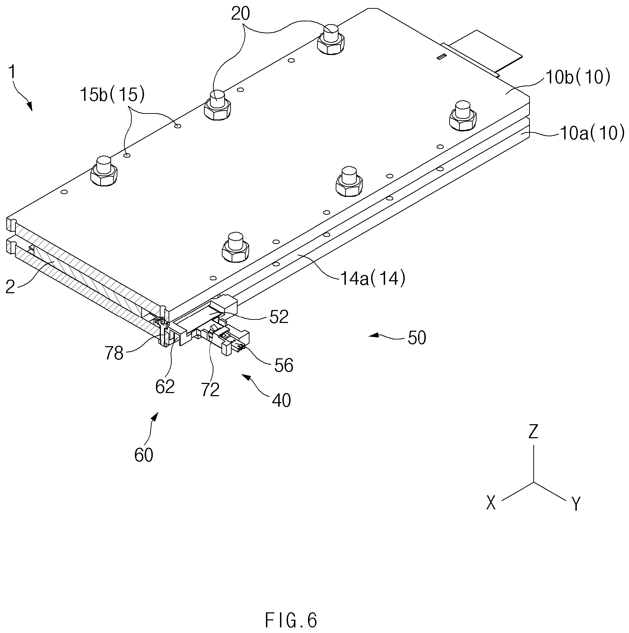

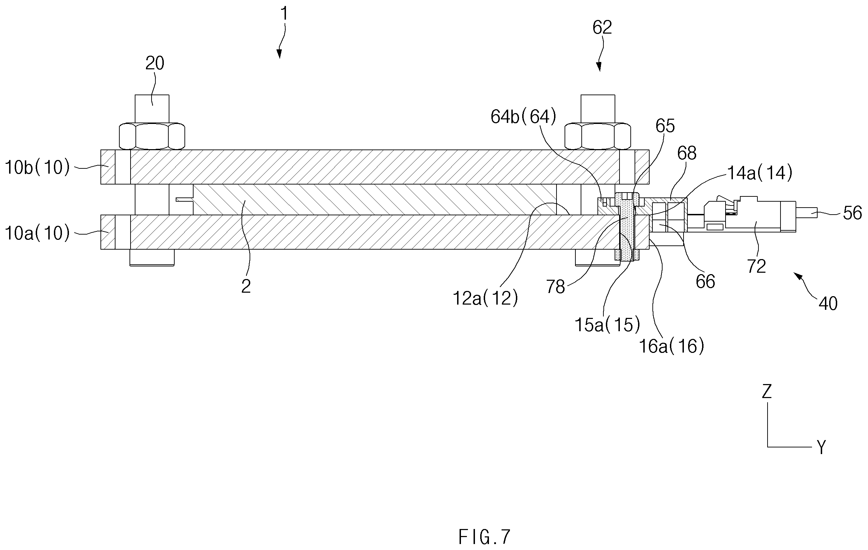

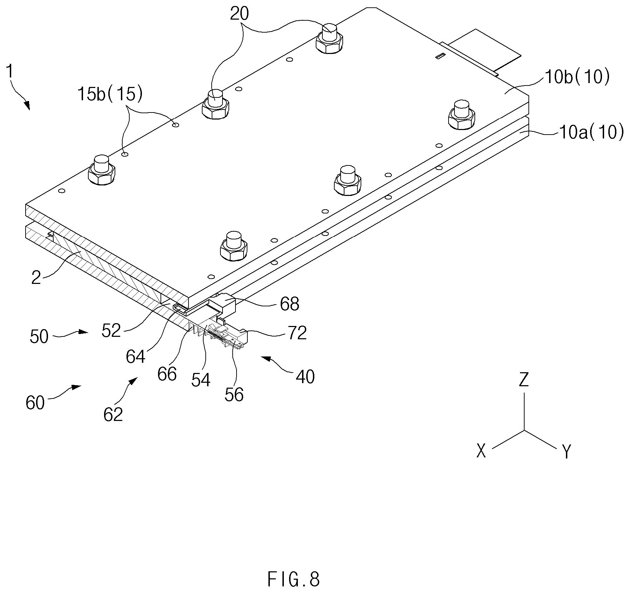

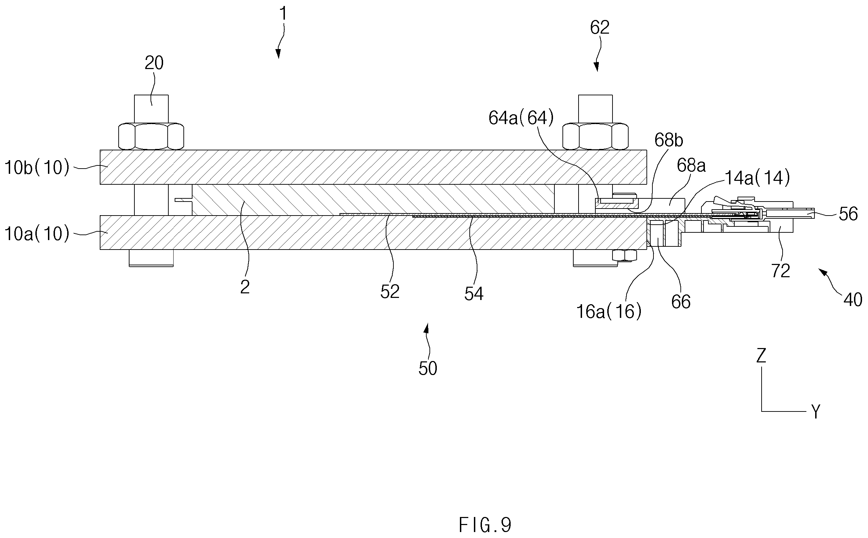

FIG. 1 is a perspective view of a battery cell testing device according to a first embodiment of the present disclosure when viewed from top. FIG. 2 is a schematic diagram showing that a sensor assembly and a processor of the battery cell testing device according to the first embodiment of the present disclosure are electrically connected to a battery cell. FIG. 3 is an exploded perspective view of the battery cell testing device according to the first embodiment of the present disclosure. FIG. 4 is a perspective view of the sensor assembly of the battery cell testing device according to the first embodiment of the present disclosure when viewed from top. FIG. 5 is a perspective view of the sensor assembly of the battery cell testing device according to the first embodiment of the present disclosure when viewed from bottom. FIG. 6 is a cross-sectional perspective view of the battery cell testing device according to the first embodiment of the present disclosure, showing a coupling structure between a support frame and the sensor assembly. FIG. 7 is a cross-sectional view of FIG. 6. FIG. 8 is a cross-sectional perspective view of the battery cell testing device according to the first embodiment of the present disclosure, showing a sensing portion and a substrate portion of the sensor assembly. FIG. 9 is a cross-sectional view of FIG. 8.

FIGS. 1 and 2 show the battery cell testing device 1 (hereinafter referred to as testing device) according to the first embodiment of the present disclosure. Referring to FIGS. 1 and 2, the testing device 1 according to the first embodiment of the present disclosure may be a device for determining the characteristics of the battery cell 2. In this instance, the battery cell 2 may be a pouch-type secondary battery, and the characteristics of the battery cell 2 may include resistance, current, voltage, charge/discharge rate or capacity, temperature and/or pressure of the battery cell 2.

Referring to FIGS. 1 to 3, the testing device 1 according to the first embodiment of the present disclosure may include the support frame 10. In this embodiment, the support frame 10 may be a frame for supporting the battery cell 2 being tested. To this end, the support frame 10 may be made of metal or plastic having a predetermined stiffness.

In this embodiment, the support frame 10 may have a flat plate shape extended frontwards and rearwards (X axis direction). Accordingly, the battery cell 2 may be placed on one surface of the support frame 10. However, the support frame 10 is not limited to a particular shape and may have any shape for supporting the battery cell 2.

In this embodiment, the support frame 10 may include a pair of support frames 10 arranged parallel to each other. As shown, the pair of support frames 10 may include a first support frame 10a and a second support frame 10b arranged apart from each other in the top-bottom direction (Z axis direction).

In this embodiment, the first support frame 10a and the second support frame 10b may be arranged parallel to each other. Accordingly, the battery cell 2 may be fixed and supported between the first support frame 10a and the second support frame 10b.

In this embodiment, the first support frame 10a and the second support frame 10b may have a fixing hole 13. The fixing hole 13 may be a hole for fixing the relative position between the first support frame 10a and the second support frame 10b.

To this end, the relative position between the first support frame 10a and the second support frame 10b may be adjusted so that the fixing hole 13a of the first support frame 10a and the fixing hole 13b of the second support frame 10b may be coaxially arranged in the top-bottom direction (Z axis direction).

In this embodiment, the fixing hole 13 may include a plurality of fixing holes 13. Additionally, the plurality of fixing holes 13 may be arranged at an interval along the periphery of the support frame 10. This is to prevent interference between a fastener 20 installed at the fixing hole 13 and the battery cell 2 placed at a central part of the support frame 10.

In this embodiment, the plurality of fixing holes 13 may be arranged along two lines. Additionally, each line may be disposed along the periphery on two sides of the support frame 10 (Y axis direction). Accordingly, the relative position between the first support frame 10a and the second support frame 10b may be fixed in a balanced manner.

In this embodiment, the support frame 10 may have a frame-side coupling hole 15. The frame-side coupling hole 15 may be a hole for coupling the sensor assembly 40 as described below to the support frame 10.

In this instance, the frame-side coupling hole 15 may include a plurality of frame-side coupling holes 15. Additionally, the plurality of frame-side coupling holes 15 may be arranged at an interval along the periphery of the support frame 10. The sensor assembly 40 as described below may be coupled to the support frame 10 using some selected holes of the plurality of frame-side coupling holes 15.

Accordingly, the sensor assembly 40 may be coupled to any part of the periphery of the support frame 10. Through this, the relative position between the sensor assembly 40 and the battery cell 2 placed on the support frame 10 may be freely controlled. It will be described in detail below with the sensor assembly 40.

Meanwhile, in this embodiment, the plurality of frame-side coupling holes 15 may be arranged at an interval along two lines. Additionally, each line may be disposed along the periphery on two sides of the support frame 10 (Y axis direction).

Accordingly, the sensor assembly 40 as described below may be installed at any part of the periphery on the side of the support frame 10. The position or arrangement of the frame-side coupling holes 15 may be properly modified according to needs, taking into account the relative position between the sensor assembly 40 and the battery cell 2.

Meanwhile, in this embodiment, the first support frame 10a and the second support frame 10b are shown as having the same shape, but the first support frame 10a and the second support frame 10b may be provided in different shapes. Additionally, provided that the battery cell 2 may be stably supported, only one support frame 10 may be included.

Referring to FIGS. 1 and 3, the testing device 1 according to the first embodiment of the present disclosure may include the fastener 20. The fastener 20 may be configured to fix the relative position between the first support frame 10a and the second support frame 10b. Through this, the battery cell 2 between the first support frame 10a and the second support frame 10b may be stably supported and fixed.

In this embodiment, the fastener 20 may include a bolt 20a and a nut 20b. The bolt 20a may pass through the fixing hole 13a of the first support frame 10a and the fixing hole 13b of the second support frame 10b coaxially arranged. Additionally, the nut 20b may be coupled to the end portion of the bolt 20a.

Accordingly, the first support frame 10a and the second support frame 10b may be stably coupled and fixed. In this instance, to enhance the fixation and coupling strength of the support frame 10, the fastener 20 may include a plurality of fasteners 20 and each of them may be coupled to each of the plurality of the fixing hole 13.

Meanwhile, the fastener 20 may be modified according to needs. The fastener 20 is not limited to a particular type or shape and may have any type or shape for coupling and fixing the first support frame 10a and the second support frame 10b.

For example, the fastener 20 may include a screw, a bolt or a rivet. Alternatively, the fastener 20 may be a protrusion formed in any one of the first support frame 10a and the second support frame 10b, and configured to be coupled the fixing hole 13 of the other one with a shape fit.

Referring to FIGS. 1 and 2, the testing device 1 according to the first embodiment of the present disclosure may include the processor 30. The processor 30 may be configured to determine the characteristics of the battery cell 2 and create data.

As an example, the processor 30 may be configured to determine the resistance or impedance of the battery cell 2 and create data. To this end, the processor 30 may have an Electrochemical Impedance Spectroscopy (EIS) circuit.

As another example, the processor 30 may be configured to determine the voltage or current of the battery cell 2 and create data. To this end, the processor 30 may have a cycler circuit, and be electrically connected to electrode leads 2a, 2b of the battery cell 2.

As still another example, the processor 30 may be configured to determine the temperature or pressure of the battery cell 2 and create data. To this end, the processor 30 may be electrically connected to the sensor assembly 40 as described below.

Meanwhile, referring to FIGS. 3 to 5, the testing device 1 according to the first embodiment of the present disclosure may include the sensor assembly 40. The sensor assembly 40 may be an assembly installed at the support frame 10 to measure the characteristics or performance of the battery cell 2.

Referring to FIGS. 4 to 9, the sensor assembly 40 of the testing device 1 according to the first embodiment of the present disclosure may include a sensor 50. The sensor 50 may be configured to perform the main function of the sensor assembly 40, i.e., measuring the characteristics of the battery cell 2.

In this embodiment, the sensor 50 may include the sensing portion 52. As shown, at least part of the sensing portion 52 may be disposed between the battery cell 2 and the first support frame 10a. In this instance, the outer surface of the sensing portion 52 may be disposed in contact with the battery cell 2.

In this embodiment, the sensing portion 52 may be configured to sense the characteristics of the battery cell 2. For example, the sensing portion 52 may be configured to sense the temperature or pressure of the battery cell 2 in contact with the sensing portion 52. That is, the sensor 50 may be a temperature sensor or a pressure sensor.

In this instance, in this embodiment, the sensing portion 52 may have a film or sheet shape. Accordingly, the sensing portion 52 may be disposed between an upper surface 14 of the support frame 10 and a lower surface of the battery cell 2 more easily. Additionally, as the upper surface of the sensing portion 52 may contact the lower surface of the battery cell 2 through a wider area, the sensing portion 52 may sense the characteristics of the battery cell 2 more sensitively and quickly.

Meanwhile, in this embodiment, the sensor 50 may include the substrate portion 54. The substrate portion 54 may be a substrate for converting the characteristics of the battery cell 2 sensed by the sensing portion 52 into an electrical signal. To this end, the substrate portion 54 may include a circuit for performing the above-described function.

In this embodiment, the substrate portion 54 may be coupled to a lower surface of the sensing portion 52. In other words, the substrate portion 54 may be disposed between the lower surface of the sensing portion 52 and an upper surface 12a of the first support frame 10a.

Additionally, in this embodiment, the substrate portion 54 may be extended from the lower surface of the sensing portion 52 in an outward direction (the positive direction of Y axis) of the periphery of the support frame 10. In this instance, the end portion of the substrate portion 54 in the extension direction may be located outside of the periphery of the support frame 10.

Meanwhile, in this embodiment, the sensor 50 may include a connector portion 56. The connector portion 56 may be a connector for transmitting the electrical signal from the substrate portion 54 to the processor 30 (shown in FIG. 2).

To this end, the connector portion 56 may include a terminal. However, the connector portion 56 is not limited to a particular structure or type and may have such a structure or type that the connector portion 56 may be electrically connected to other component than the substrate portion 54.

In this embodiment, the connector portion 56 may be coupled to the end portion of the substrate portion 54 in the extension direction. Additionally, the connector portion 56 may be sufficiently extended outward from the periphery of the support frame 10. This may be for easier electrical connection to the component located outside of the support frame 10.

Meanwhile, the sensor 50 of the testing device 1 according to the first embodiment of the present disclosure is not limited to a particular structure or type and may include any structure or type for sensing the characteristics of the battery cell 2, and the structure or type may be properly modified, taking into account the type or shape of the battery cell 2, the physical quantities to measure and so on.

Referring to FIGS. 4 to 9, the sensor assembly 40 of the testing device 1 according to the first embodiment of the present disclosure may include a holder 60. The holder 60 may be coupled to the support frame 10 to support the sensor 50.

In this embodiment, the holder 60 may include a holder body portion 62. The holder body portion 62 may be configured to tightly fix the sensing portion 52 of the sensor 50 to the support frame 10.

To this end, in this embodiment, the holder body portion 62 may include a main body portion 64. The main body portion 64 may be placed on the peripheral part of the upper surface 12a of the first support frame 10a.

Referring to FIGS. 3 to 5, 7 and 8, in this embodiment, a central part 64a of the main body portion 64 may have a plate shape parallel to the upper surface 12a of the first support frame 10a. Additionally, the central part 64a may be extended in the width direction (X axis direction) of the sensing portion 52.

In this instance, in this embodiment, the central part 64a of the main body portion 64 may be spaced somewhat apart from the upper surface 12a of the first support frame 10a. Accordingly, a part of the sensing portion 52 may be disposed between the upper surface 12a of the first support frame 10a and the central part 64a of the main body portion 64. Accordingly, the sensing portion 52 may be stably fixed to the upper surface of the first support frame 10a.

Additionally, in this embodiment, as the central part 64a has the plate shape, the main body portion 64 may be inserted into the narrow gap between the first support frame 10a and the second support frame 10b, thereby bringing the sensing portion 52 having the film or sheet shape into close contact with the first support frame 10a more effectively.

Meanwhile, referring to FIGS. 3 to 7, in this embodiment, the main body portion 64 may include a side part 64b on the side of the central part 64a. As shown, the side part 64b may be located at each of two sides of the sensing portion 52 in the width direction (X axis direction).

In this embodiment, a lower surface of the side part 64b may contact the upper surface 12a of the first support frame 10a. Accordingly, the supporting force of the first support frame 10a may support the main body portion 64.

In this instance, in this embodiment, the side part 64b of the main body portion 64 may have a holder-side coupling hole 65. The holder-side coupling hole 65 may be a hole for coupling the sensor assembly 40 to the first support frame 10.

More specifically, the relative position between the sensor assembly 40 and the support frame 10 may be adjusted so that the holder-side coupling hole 65 and the frame-side coupling hole 15a may be coaxially arranged in the top-bottom direction (Z axis direction).

Additionally, when a coupler 78 as described below passes through and is coupled to the holder-side coupling hole 65 and the frame-side coupling hole 15a, the sensor assembly 40 may be coupled to the first support frame 10a. It will be described in more detail below with the coupler 78.

Meanwhile, in this embodiment, the holder-side coupling hole 65 may include a plurality of holder-side coupling holes 65. As shown, the holder-side coupling hole 65 may include two holder-side coupling holes 65. In this instance, the two holder-side coupling holes 65 may be arranged apart from each other in a direction (X axis direction) parallel to the periphery of the support frame 10 with the sensing portion 52 interposed therebetween. Accordingly, the sensor assembly 40 may be coupled and fixed to the support frame 10 in a more stable and balanced manner.

Meanwhile, in this embodiment, the holder body portion 62 may include a sub body portion 66. The sub body portion 66 may be extended in the thickness direction (Z axis direction) of the first support frame 10a.

In this embodiment, the side of the sub body portion 66 may contact a lateral face 16a of the first support frame 10a. In this instance, the lateral face 16a of the first support frame 10a may be a surface formed in the thickness direction (Z axis direction) along the periphery of the first support frame 10a. Accordingly, the supporting force of the first support frame 10a may support and fix the holder 60.

In particular, according to this embodiment, the main body portion 64 of the holder 60 may be supported and fixed in the top-bottom direction (Z axis direction) by the upper surface 12a of the first support frame 10a, and the sub body portion 66 may be supported and fixed in the outward direction (Y axis direction) of the first support frame 10a by the lateral face 16a of the first support frame 10a, and thus the holder 60 may be fixed and supported to the first support frame 10a more stably.

Meanwhile, in this embodiment, when viewed from the thickness direction (Z axis direction) of the first support frame 10a, the length of the sub body portion 66 may be smaller than the thickness of the first support frame 10a. It may be to achieve more compact design of the sensor assembly 40.

Referring to FIGS. 4 to 9, the holder body portion 62 of the testing device 1 according to the first embodiment of the present disclosure may include a body connection portion 68. The body connection portion 68 may connect the main body portion 64 to the sub body portion 66. Accordingly, the supporting force of the upper surface 12a and the lateral face 16a of the first support frame 10a may be applied to the holder 60 together.

In this instance, in this embodiment, the body connection portion 68 may be configured to surround an edge 14a of the first support frame 10a. In this instance, the edge 14a of the first support frame 10a may be an edge sharply protruded at the periphery of the first support frame 10a. The edge 14a may be at the intersection of the upper surface 12a and the lateral face 16a of the first support frame 10a.

In this embodiment, the body connection portion 68 may be supported in contact with the edge 14a of the first support frame 10a. To this end, the body connection portion 68 may conform to the shape of the edge 14a.

In other words, the body connection portion 68 may be recessed concavely in a direction in which the edge 14a is sharply protruded. To put it another way, the body connection portion 68 may be bent to conform to the shape of the edge 14a.

The holder body portion 62 may be coupled to the periphery of the first support frame 10a by the body connection portion 68 with a shape fit. Accordingly, the holder 60 may be fixed and supported by the first support frame 10a more stably.

Meanwhile, in this embodiment, the body connection portion 68 may have a sensor support groove 69a. The sensor support groove 69a may have a concavely recessed shape inwards from the body connection portion 68.

Additionally, a part of the sensing portion 52 and/or a part of the substrate portion 54 may be placed and supported on the bottom surface of the sensor support groove 69a. Accordingly, the sensor 50 may be supported and fixed by the holder 60. Additionally, the sensing portion 52 and/or the substrate portion 54 may be covered by the holder 60 to protect it from external pollution or shocks.

In this instance, in this embodiment, as the sensing portion 52 and the substrate portion 54 has a flat shape, the bottom surface of the sensor support groove 69a may also have a flat shape to conform to the shape. Through this, the sensing portion 52 and/or the substrate portion 54 may be stably supported and fixed in contact with the bottom surface of the sensor support groove 69a.

Meanwhile, referring to FIGS. 4 to 7, in this embodiment, the body connection portion 68 is configured to surround the edge 14a of the first support frame 10a. Accordingly, at least part of the sensing portion 52 and/or the substrate portion 54 may be configured to pass through the body connection portion 68 so as to be placed between the main body portion 64 and the first support frame 10a.

To this end, in this embodiment, the body connection portion 68 may have a sensor support hole 69b. The sensor support hole 69b may be a hole through which the sensing portion 52 and/or the substrate portion 54 passes. By the sensor support hole 69b, the holder body portion 62 may support around a part of the sensing portion 52 and/or the substrate portion 54.

In this instance, in this embodiment, as the sensing portion 52 and/or the substrate portion 54 is supported in contact with the bottom surface of the sensor support groove 69a, the sensor support hole 69b may be formed in the inner wall of the sensor support groove 69a.

Additionally, in this embodiment, the sensor support hole 69b may have a slit shape extended in the width direction (X axis direction) to conform to the shape of the sensing portion 52 and the substrate portion 54 of the flat shape.

Meanwhile, referring to FIGS. 3 to 7, the holder 60 of the testing device 1 according to the first embodiment of the present disclosure may include a connector support portion 72. In this embodiment, the connector support portion 72 may be configured to support a part of the connector portion 56 and/or the substrate portion 54 of the sensor 50.

In this embodiment, the connector support portion 72 may be extended parallel to the extension direction (the positive direction of Y axis) of the connector portion 56 from the holder body portion 62. In other words, the connector support portion 72 may be extended in the outward direction of the periphery of the first support frame 10a.

In this embodiment, a part of the substrate portion 54 and the connector portion 56 may be placed on the upper surface of the connector support portion 72. In this instance, the part of the substrate portion 54 may be a part of the substrate portion 54 protruded to the outside of the holder body portion 62.

Accordingly, the connector support portion 72 may support the lower side of the connector portion 56 and/or the substrate portion 54. Also, the connector support portion 72 may be configured to support them from above.

In this embodiment, the connector support portion 72 may have a connector support groove 73. The connector support groove 73 may be a groove into which at least part of the connector portion 56 is inserted.

In this embodiment, the connector support groove 73 may be formed in the upper surface of the connector support portion 72. Additionally, the connector support groove 73 may be concavely recessed downwards. Accordingly, at least part of the connector portion 56 may be inserted and fixed to the connector support groove 73 to protect it from external shocks or pollution.

In this instance, in this embodiment, the shape of the connector support groove 73 may conform to the shape of the connector portion 56. In other words, the connector portion 56 may be coupled to the connector support groove 73 with a shape fit. Accordingly, the fixation or coupling strength between the connector support portion 72 and the connector portion 56 may be enhanced.

Meanwhile, referring to FIG. 4, in this embodiment, the holder 60 may include a connector fixing portion 74. The connector fixing portion 74 may be configured to enhance the coupling or fixation strength between the connector portion 56 and the holder 60.

According to this embodiment, as shown, the connector fixing portion 74 may have a ring shape through which the connector portion 56 may pass. In this instance, the connector fixing portion 74 may be disposed on the connector support groove 73.

Through this, the connector fixing portion 74 may prevent the connector portion 56 from slipping out of the connector support groove 73. However, the connector fixing portion 74 is not limited to a particular shape or structure and may have any shape or structure for enhancing the coupling strength between the connector support portion 72 and the connector portion 56.

Referring to FIG. 4, in this embodiment, the holder 60 may include a substrate fixing portion 76. The substrate fixing portion 76 may be configured to fix the substrate portion 54 to the connector support portion 72.

In this embodiment, as shown, a part of the substrate portion 54 may be extended outward from the holder body portion 62 and placed on the upper surface of the connector support portion 72. In this instance, the substrate fixing portion 76 may be protruded from the upper surface of the connector support portion 72 at the periphery of the substrate portion 54. Additionally, the substrate fixing portion 76 may be extended along the periphery of the substrate portion 54.

The substrate fixing portion 76 may cover the peripheral part of the substrate portion 54 to protect from external shocks or pollution. Additionally, the substrate fixing portion 76 may perform the function of guide the substrate portion 54 to the upper surface of the connector support portion 72 when the sensor 50 is coupled to the holder 60, thereby enhancing the assembly of the holder 60 and the sensor 50.

Meanwhile, in this embodiment, the substrate fixing portion 76 may include a pair of the substrate fixing portions 76, each disposed at each of two sides of the substrate portion 54 in the width direction (X axis direction). Through this, the substrate fixing portions 76 may fix and protect the substrate portion 54 in a balanced manner.

Referring to FIGS. 3 to 7, the sensor assembly 40 of the testing device 1 according to the first embodiment of the present disclosure may include the coupler 78. The coupler 78 may be configured to couple the holder 60 of the sensor assembly 40 to the support frame 10.

In this instance, in this embodiment, the sensor assembly 40 may be detachably coupled to the support frame 10. Detachably coupling may refer to coupling or decoupling by hand or without a special tool or device. The used tool or device that is not special, may include a driver, a spanner, or an electric drill.

In this embodiment, the coupler 78 may include a bolt 78a and a nut 78b. By the coupler 78, the sensor assembly 40 may be detachably coupled to the support frame 10.

Describing in detail, in a state that the frame-side coupling hole 15 of the support frame 10 and the holder-side coupling hole 65 of the sensor assembly 40 are coaxially arranged in the top-bottom direction (Z axis direction), the bolt 78a may pass through and be inserted into coupling holes 15, 65, and the nut 78b may be fastened to the end portion of the bolt 78a, and thus the sensor assembly 40 may be coupled to the support frame 10.

Accordingly, an operator using the testing device 1 may decouple the sensor assembly 40 from the support frame 10 and move the sensor assembly 40 to another location to couple the sensor assembly 40 to the support frame 10 again. Accordingly, in this embodiment, the relative position between the sensor 50 and the battery cell 2 may be freely controlled or changed.

Through this, the testing device 1 according to this embodiment may determine the characteristics of any part of the battery cell 2 accurately and conveniently and create data. The data may be used to evaluate stability or performance of the battery cell 2 more accurately.

Meanwhile, in this embodiment, to detachably couple the sensor assembly 40 to the support frame 10, the coupler 78 including the bolt 78a and the nut 79b is used, but a variety of modifications may be made to the coupling structure for detachably coupling the sensor assembly 40 to the support frame 10 according to needs.

For example, the holder body portion 62 of the holder 60 may have a protrusion protruded downwards, and the protrusion may be configured to be inserted into the frame-side coupling hole 15 of the support frame 10.

Additionally, in this embodiment, the sensor assembly 40 is configured to be coupled to the first support frame 10a, but may be configured to be coupled to the second support frame 10b.

Hereinafter, the testing device according to another embodiment of the present disclosure will be described with reference to other drawings.

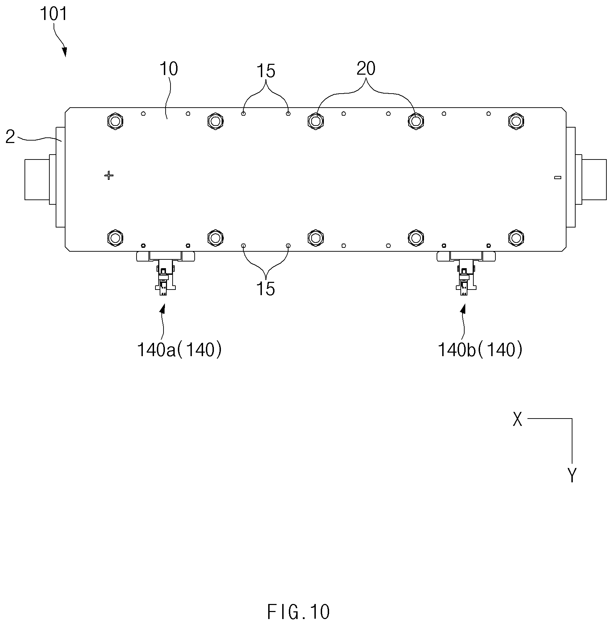

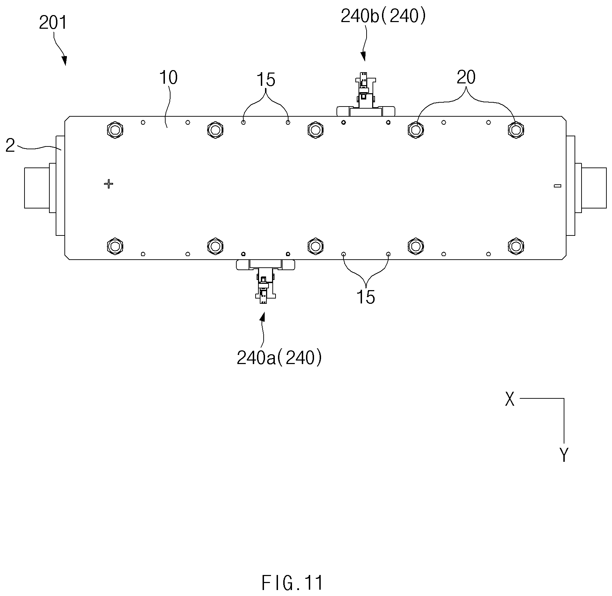

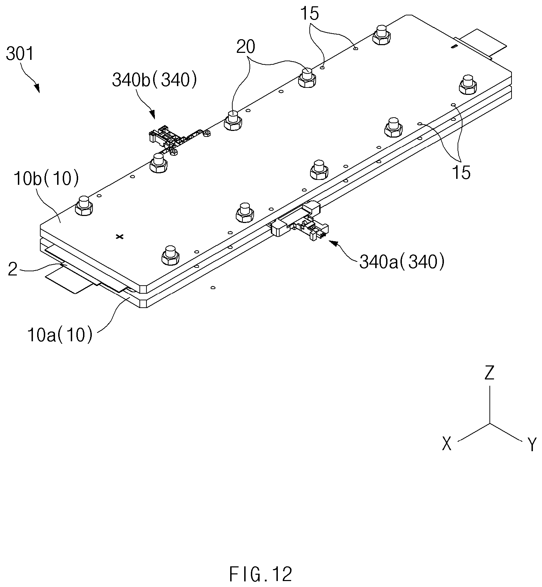

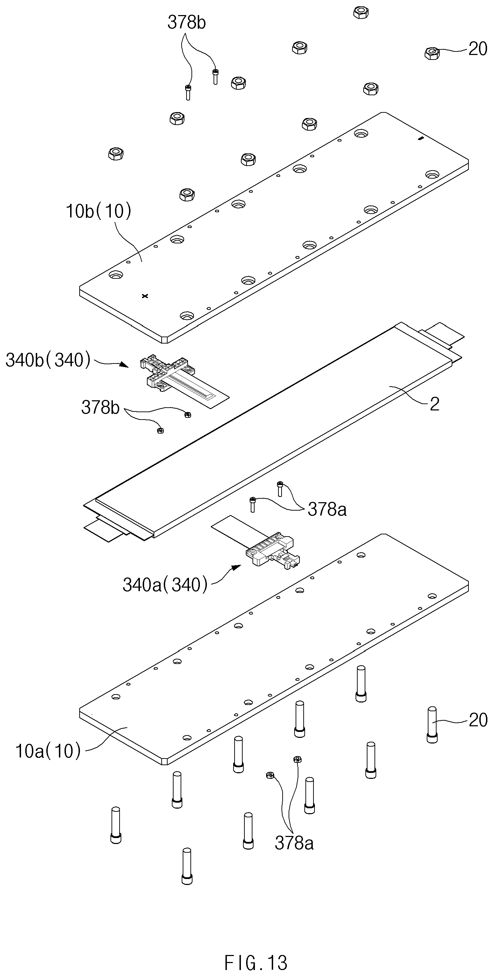

FIG. 10 is a plan view of the battery cell testing device according to a second embodiment of the present disclosure. FIG. 11 is a plan view of the battery cell testing device according to a third embodiment of the present disclosure. FIG. 12 is a perspective view of the battery cell testing device according to a fourth embodiment of the present disclosure when viewed from top. FIG. 13 is an exploded perspective view of the battery cell testing device according to a fourth embodiment of the present disclosure.

FIG. 10 shows the testing device 101 according to the second embodiment of the present disclosure. Referring to FIG. 10, the sensor assembly 140 of the testing device 101 according to the second embodiment of the present disclosure may include a plurality of sensor assemblies 140.

As shown, in this embodiment, the sensor assembly 140 may include a first sensor assembly 140a and a second sensor assembly 140b. In this instance, each of the first sensor assembly 140a and the second sensor assembly 140b may be configured to sense different characteristics of the battery cell.

For example, the first sensor assembly 140a may be configured to measure the temperature of the battery cell, and the second sensor assembly 140b may be configured to measure the pressure of the battery cell. The first sensor assembly 140a and the second sensor assembly 140b may be also configured to determine the same characteristic.

In this embodiment, the first sensor assembly 140a and the second sensor assembly 140b may be arranged parallel to each other along the periphery of the support frame 10. In this instance, the first sensor assembly 140a and the second sensor assembly 140b may be spaced apart from each other in the extension direction (X axis direction) of the support frame 10.

Accordingly, each of the first sensor assembly 140a and the second sensor assembly 140b may individually sense the characteristics of the battery cell with minimum interferences or influences between them. Accordingly, it may be possible to simultaneously determine different characteristics of the battery cell or the characteristics of different parts of the battery cell.

FIG. 11 shows the testing device 201 according to the third embodiment of the present disclosure. Referring to FIG. 11, the sensor assembly 240 of the testing device 201 according to the third embodiment of the present disclosure may include a plurality of sensor assemblies 240.

As shown, in this embodiment, the sensor assembly 240 may include a first sensor assembly 240a and a second sensor assembly 240b. In this instance, each of the first sensor assembly 240a and the second sensor assembly 240b may be configured to sense different characteristics of the battery cell.

For example, the first sensor assembly 240a may be configured to measure the temperature of the battery cell, and the second sensor assembly 240b may be configured to measure the pressure of the battery cell. The first sensor assembly 240a and the second sensor assembly 240b may be also configured to determine the same characteristic.

In this embodiment, each of the first sensor assembly 240a and the second sensor assembly 240b may be coupled to the peripheral part on each of two sides of the support frame 10 (Y axis direction). In this instance, the peripheral parts on the two sides of the support frame 10 may be opposite peripheral parts.

Accordingly, the first sensor assembly 240a and the second sensor assembly 240b may be disposed opposite to each other. Accordingly, it may be possible to simultaneously determine different characteristics of the battery cell or the characteristics of different parts of the battery cell.

In this instance, in this embodiment, the first sensor assembly 240a and the second sensor assembly 240b may be arranged in a staggered manner in the width direction (Y axis direction) of the support frame 10. Through this, it may be possible to minimize interferences or influences between the first sensor assembly 140a and the second sensor assembly 140b.

FIGS. 12 and 13 show the testing device 301 according to the fourth embodiment of the present disclosure. Referring to FIGS. 12 and 13, the sensor assembly 340 of the testing device 301 according to the fourth embodiment of the present disclosure may include a plurality of sensor assemblies 340.

As shown, in this embodiment, the sensor assembly 340 may include a first sensor assembly 340a and a second sensor assembly 340b. In this instance, each of the first sensor assembly 340a and the second sensor assembly 340b may be configured to sense different characteristics of the battery cell.

For example, the first sensor assembly 340a may be configured to measure the temperature of the battery cell, and the second sensor assembly 340b may be configured to measure the pressure of the battery cell. The first sensor assembly 340a and the second sensor assembly 340b may be also configured to determine the same characteristic.

In this instance, in this embodiment, the first sensor assembly 340a may be coupled to the first support frame 10a placed on the lower side of the battery cell 2 (the negative direction of Z axis), and the second sensor assembly 340b may be coupled to the second support frame 10b placed on the upper side of the battery cell 2 (the positive direction of Z axis).

To this end, the first sensor assembly 340a may be coupled to the first support frame 10a by a first coupler 378a, and the second sensor assembly 340b may be coupled to the second support frame 10b by a second coupler 378b.

In this instance, the first coupler 378a may include a bolt passing through the first support frame 10a and the holder of the first sensor assembly 340a and a nut coupled to the end portion of the bolt, and the second coupler 378b may include a bolt passing through the second support frame 10b and the holder of the second sensor assembly 340b and a nut coupled to the end portion of the bolt.

Accordingly, the sensor of the first sensor assembly 340a may determine the characteristics of the battery cell 2 between the battery cell 2 and the first support frame 10a, and the sensor of the second sensor assembly 340b may determine the characteristics of the battery cell 2 between the battery cell 2 and the second support frame 10b. Through this, it may be possible to simultaneously determine different characteristics of the battery cell or the characteristics of different parts of the battery cell.

Additionally, as in this embodiment, when the first sensor assembly 340a and the second sensor assembly 340b are coupled to the first support frame 10a and the second support frame 10b, respectively, the first sensor assembly 340a and the second sensor assembly 340b may be arranged such that they overlap in the top-bottom direction (Z axis direction) without interferences or influences between them. Through this, the testing device 301 may be formed with more compact design.

Meanwhile, the previous embodiment is described on the premise that the battery cell being tested is a pouch-type secondary battery, but the battery cell that may be tested by the testing device according to an embodiment is not limited to a particular type or shape. For example, the battery cell to test may be a cylindrical secondary battery, and the shape or structure of the support frame and the sensor assembly may be properly modified according to the shape or type of the battery cell being tested.

Although the present disclosure has been hereinabove described with regard to a limited number of embodiments and drawings, the present disclosure is not limited thereto, and may be embodied in different forms by persons having ordinary skill in the technical field pertaining to the present disclosure within the technical aspect of the present disclosure and the appended claims and their equivalent scope.

### [List of Reference Numerals]

1, 101, 201, 301: Battery cell testing device
2: Battery cell
10: Support frame
20: Fastener
30: Processor
40, 140, 240, 340: Sensor assembly
50: Sensor
60: Holder

## Claims

1. A battery cell testing device for determining characteristics of a battery cell, the battery cell testing device comprising:
a support frame configured to support the battery cell; and
a sensor assembly disposed at a side of the support frame and configured to sense the characteristics of the battery cell,
wherein the sensor assembly includes:
a sensor configured to sense the characteristics of the battery cell; and
a holder coupled to the support frame to support the sensor.

2. The battery cell testing device according to claim 1,
wherein the holder is detachably coupled to the support frame.

3. The battery cell testing device according to claim 1,
wherein the support frame has a plate shape, and
wherein the holder is coupled to a peripheral part of the support frame.

4. The battery cell testing device according to claim 3,
wherein the holder includes:
a holder body portion coupled to the support frame with at least part of the sensor disposed therebetween.

5. The battery cell testing device according to claim 4,
wherein the sensor includes:
a sensing portion supported by the holder body portion; and
a connector portion extended outward from the support frame to electrically connect the sensing portion to an outside, and
wherein the holder further includes:
a connector support portion extended from the holder body portion to the outside of the support frame to support the connector portion.

6. The battery cell testing device according to claim 5,
wherein the connector support portion is extended parallel to the connector portion.

7. The battery cell testing device according to claim 5,
wherein the connector support portion has a connector support groove which is concavely recessed such that at least part of the connector portion is inserted into the connector support groove.

8. The battery cell testing device according to claim 5,
wherein the holder further includes:
a connector fixing portion formed on an outer surface of the connector support portion in a ring shape to catch the connector portion.

9. The battery cell testing device according to claim 5,
wherein the sensor further includes:
a substrate portion disposed between the sensing portion and the connector portion to connect them and placed on a side of the connector support portion, and
wherein the holder further includes:
a substrate fixing portion protruded outward from the connector support portion along a periphery of the substrate portion.

10. The battery cell testing device according to claim 4, wherein the holder body portion includes:
a main body portion having a flat plate shape such that at least part of the sensor is disposed between the main body portion and a surface of the support frame.

11. The battery cell testing device according to claim 10,
wherein the holder body portion includes:
a sub body portion extended in a thickness direction of the support frame into contact with the side of the support frame; and
a body connection portion configured to surround an edge at the periphery of the support frame to connect the main body portion to the sub body portion.

12. The battery cell testing device according to claim 11,
wherein the holder body portion is coupled to the edge at the periphery of the support frame with a shape fit.

13. The battery cell testing device according to claim 11,
wherein the body connection portion has a sensor support hole through which at least part of the sensor passes.

14. The battery cell testing device according to claim 13,
wherein the body connection portion has a sensor support groove which is recessed such that the at least part of the sensor is placed on the sensor support groove, and
wherein the sensor support hole is formed in an inner wall of the sensor support groove.

15. The battery cell testing device according to claim 10,
wherein the support frame has a frame-side coupling hole at the peripheral part,
wherein the main body portion has a holder-side coupling hole connected to the frame-side coupling hole, and
wherein the holder and the support frame are coupled by a coupler passing through the frame-side coupling hole and the holder-side coupling hole.

16. The battery cell testing device according to claim 15,
wherein the frame-side coupling hole includes a plurality of frame-side coupling holes arranged at an interval along the periphery of the support frame, and
wherein the holder-side coupling hole is connected to any one of the plurality of frame-side coupling holes.

17. The battery cell testing device according to claim **1,**
wherein the support frame includes:
a first support frame and a second support frame arranged parallel to each other with the battery cell disposed therebetween, and
wherein the sensor assembly includes:
a first sensor assembly and a second sensor assembly coupled to the first support frame and the second support frame, respectively.

18. The battery cell testing device according to claim 1,
wherein the sensor assembly includes:
a first sensor assembly and a second sensor assembly disposed at two opposite sides of the support frame.

19. The battery cell testing device according to claim **1,**
wherein the sensor assembly includes:
a first sensor assembly and a second sensor assembly arranged apart from each other side by side along a periphery of the support frame.

20. A sensor assembly for a battery cell for measuring characteristics of the battery cell, the sensor assembly comprising:
a sensor configured to sense the characteristics of the battery cell; and
a holder configured to be coupled to a support frame for supporting the battery cell to support the sensor.
